# EUROPEAN PATENT APPLICATION

(11) **EP 2 765 597 A2**
(43) Date of publication of application: **13.08.2014**
(21) Application number: 14153204.4
(22) Date of filing: 30.01.2014
(51) Int. Cl.: H01L 21/60, B22F 3/15

(54) **System for sintering using a pressurized gas or liquid**

(30) Priority: 11.02.2013 US 201361763084 P; 24.01.2014 US 201414163037
(71) Applicant: International Rectifier Corporation, El Segundo, CA 90245 (US)
(72) Inventor: Hauenstein, Henning M., Redondo Beach, CA 90277 (US)
(74) Representative: Dr. Weitzel & Partner

(57) **Abstract**

In an exemplary implementation, a system for producing an electrical module includes a pressure chamber (210) configured to receive a first body (202), a second body (204), and a sinter material (206) therebetween. The system further includes a pressure generator (224) configured to apply non-mechanical pressure to a gas or a liquid (232) in the pressure chamber (210) in order to attach the first body (202) to the second body (204) using the sinter material (206). The pressure chamber (210) is configured to enclose the first body (202) over the second body (204). Furthermore, the pressure chamber (210) includes a bottom opening configured to receive at least the first body (202).

## Description

### BACKGROUND

The present application claims the benefit of and priority to U.S. Provisional Patent Application Ser. No. 61/763,084, filed on February 11, 2013 and entitled "Contactless Sintering Tool and Method." The disclosure of this provisional application is hereby incorporated fully by reference into the present application.

Soldering has commonly been used to provide die attach for semiconductor devices. However, solder can be prone to wear out and degradation over the lifetime of the semiconductor devices. One typical failure mechanism for solder is growth of intermetallic compounds, which result in reduced thermal conductivity, increased resistivity, and brittleness of the die attach. Another typical failure mechanism for solder is joint fatigue in which mechanical stress can result in cracking that decreases circuit performance and potentially results in mechanical failure of the die attach.

Lead-free solder has become increasingly common due to growing environmental concerns. However, lead-free solder is generally more brittle than leaded solder, which exacerbates the aforementioned failure mechanisms. Sintering has been considered for its potential to overcome many of the shortcomings of utilizing soldering for die attach. However sintering is not widely employed, in part, due to relatively complex requirements of high pressure and temperature along with a lack of high volume manufacturing equipment.

### SUMMARY

The present disclosure is directed to sintering utilizing non-mechanical pressure, substantially as shown in and/or described in connection with at least one of the figures, and as set forth more completely in the claims.

### BRIEF DESCRIPTION OF THE DRAWINGS

Figure 1 shows a flowchart illustrating an exemplary method for fabricating an electrical module, according to an implementation disclosed in the present application.
Figure 2A illustrates a perspective cross-sectional view, which includes portions of a first body and a second body processed according to an implementation disclosed in the present application.
Figure 2B illustrates a perspective cross-sectional view, which includes a portion of a system for producing an electrical module processed according to an implementation disclosed in the present application.
Figure 2C illustrates a perspective cross-sectional view, which includes a portion of a system for producing an electrical module processed according to an implementation disclosed in the present application.
Figure 3 illustrates a perspective view of formation of an electrical module according to an implementation disclosed in the present application.

### DETAILED DESCRIPTION

The following description contains specific information pertaining to implementations in the present disclosure. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

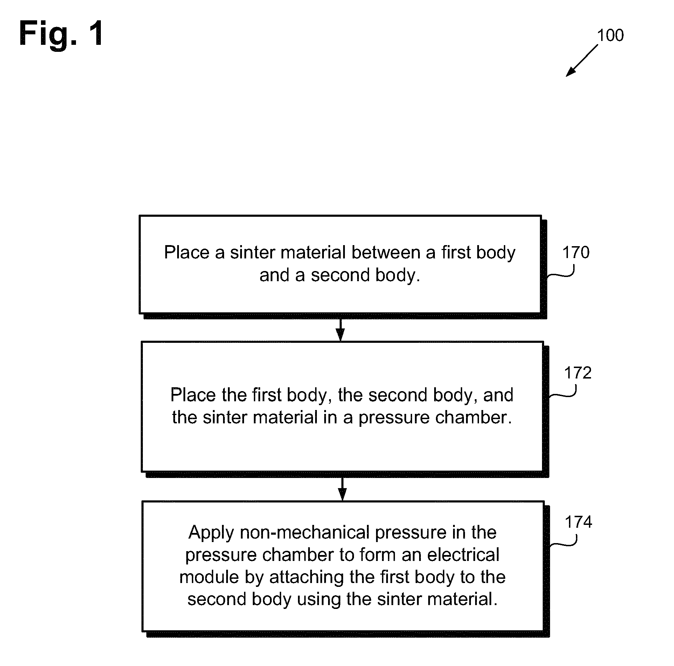

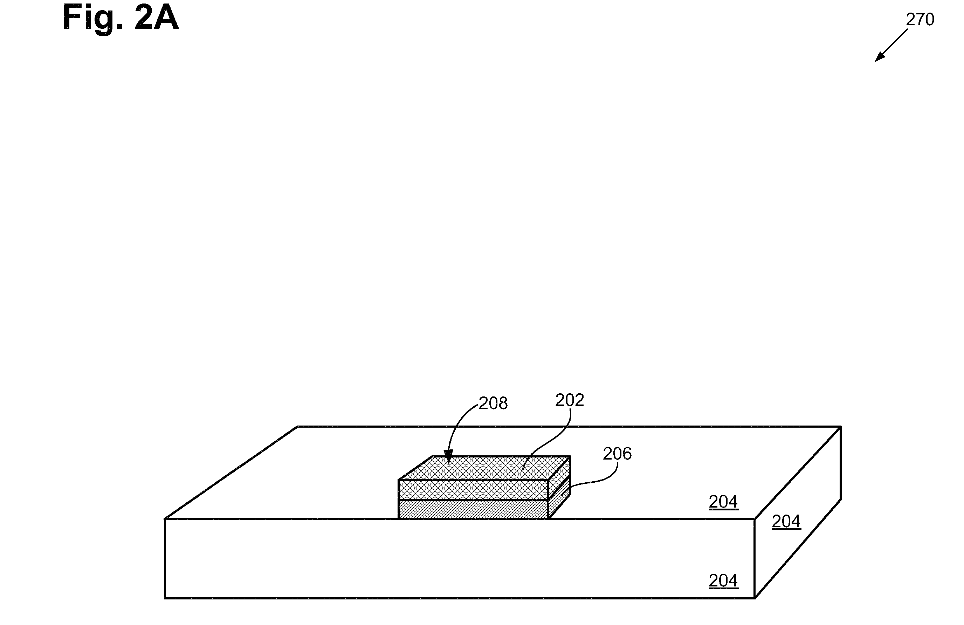

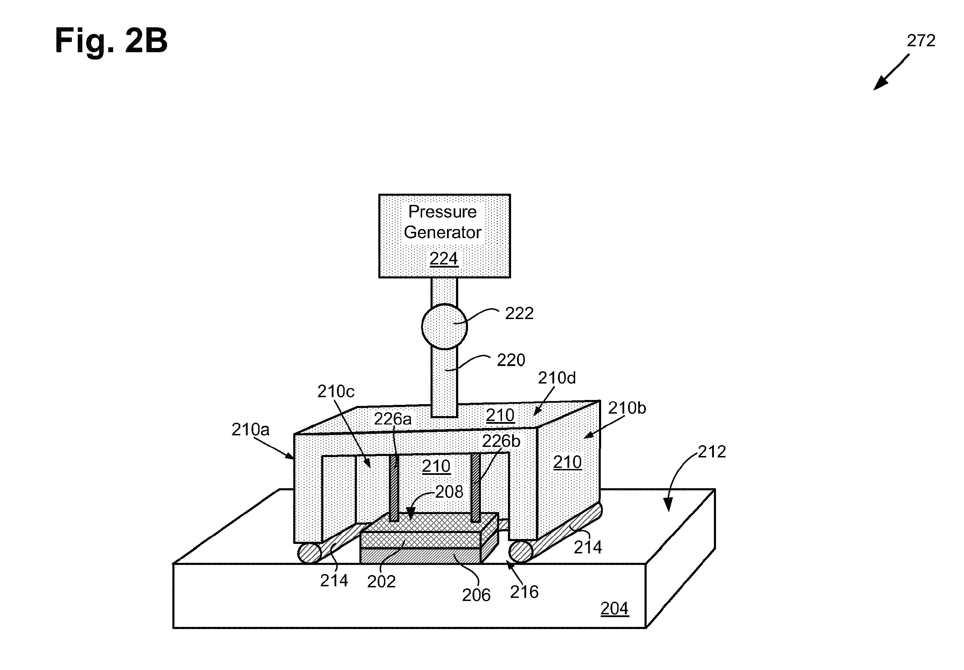

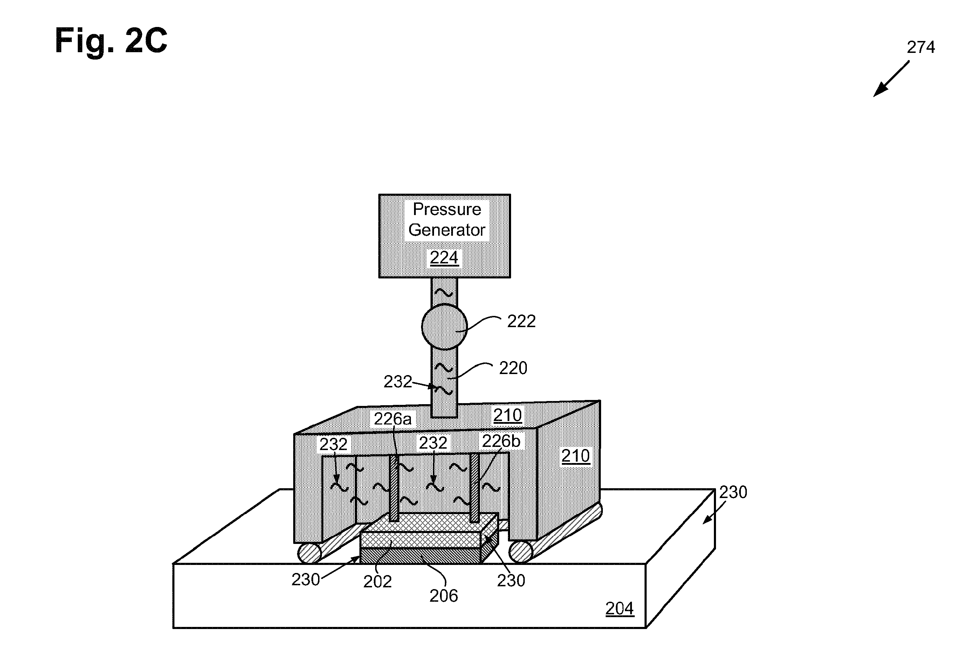

Figure 1 shows a flowchart illustrating an exemplary method for fabricating an electrical module, according to an implementation disclosed in the present application. The approach and technique indicated by flowchart 100 are sufficient to describe at least one implementation of the present disclosure, however, other implementations of the disclosure may utilize approaches and techniques different from those shown in flowchart 100. Furthermore, while flowchart 100 is described with respect to Figures 2A, 2B, and 2C, disclosed inventive concepts are not intended to be limited by specific features shown and described with respect to Figures 2A, 2B, and 2C. Furthermore, with respect to the method illustrated in Figure 1, it is noted that certain details and features have been left out of flowchart 100 in order not to obscure discussion of inventive features in the present application.

Referring to flowchart 100 of Figure 1 and to Figure 2A, flowchart 100 includes placing a sinter material (e.g., 206) between a first body (e.g., 202) and a second body (e.g., 204) (170 in Figure 1). Figure 2A illustrates a perspective cross-sectional view, which includes portions of a first body and a second body processed according to an implementation disclosed in the present application. In particular, Figure 2A shows structure 270, which includes first body 202, second body 204, and sinter material 206.

In structure 270, sinter material 206 has been placed between first body 202 and second body 204. This may be accomplished utilizing machinery, such as a pick-and-place machine, or similar, or may be accomplished by other means. First body 202 is situated over second body 204. Sinter material 206 is situated between first body 202 and second body 204. First body 202 and second body 204 are generally any two bodies capable of being attached to one another by sintering. Sinter material 206 generally includes any material capable of attaching first body 202 and second body 204 utilizing sintering.

Sinter material 206 can include pastes and/or powders (e.g. conductive pastes and powders) of various compositions. Sinter material 206 can include silver, and a specific example of a suitable paste is silver paste. Another example of sinter material 206 includes eutectically formed connections of metal alloys including various layers. Sinter material 206 can be utilized to form a bonded connection (e.g. intermetallic connection) between first body 202 and second body 204. For example, sinter material 206 may form the bonded connection between an electrode of a die (e.g. first body 202) and a conductive portion of a substrate (e.g. second body 204).

Examples for first body 202 and second body 204 include any of a substrate, a semiconductor die, a heat sink, an integrated circuit, and a composite device, as are generally represented in Figure 2A. In the implementation shown, second body 204 is significantly larger than first body 202 in the plane that receives sinter material 206. However, the relative proportions of first body 202 and second body 204 can vary. For example, first body 202 is smaller than second body 204 in the plane that receives sinter material 206 in some implementations.

As some examples of suitable substrates, first body 202 and/or second body 204 can be a metal substrate, such as a Cu-leadframe, or a ceramic based substrate. In one implementation, first body 202 and/or second body 204 is a direct bonded copper (DBC) substrate that can include various types of ceramics such as aluminum oxide, silicon nitride, and aluminum nitride. Another example is an insulated metal substrate (IMS). Sinter material 206 may be situated on an electrically conductive layer of the IMS or DBC. As yet another example, first body 202 and/or second body 204 can include a semiconductor substrate.

Examples of a suitable semiconductor die for first body 202 and/or second body 204 include various types of diode dies, or transistor dies, such as a metal-oxide-semiconductor field-effect transistor (MOSFET) die, an insulated-gate bipolar transistor (IGBT) die, a high-electron-mobility transistor (HEMT) die, a III-V transistor (e.g. a GaN transistor) die, a silicon transistor die, or a power transistor die.

In certain applications, sintering has been considered for its potential to overcome many of the shortcomings of utilizing soldering. However, sintering is not widely employed, in part, due to relatively complex requirements of high pressure and temperature along with a lack of high volume manufacturing equipment. In one approach to sintering, several MPa of mechanical pressure can be applied to top surface 208 of first body 202. However, applying the mechanical pressure presents a significant risk of cracking or otherwise significantly damaging at least first body 202. In implementations where first body 202 is a semiconductor die, cracks may occur at least in a surface passivation layer (e.g. Si-Nitride, Oxide) thereof.

High mechanical pressure should be applied homogeneously across top surface 208 to reduce the risk of damaging first body 202. However, the difficulty of homogeneously applying mechanical pressure to top surface 208 increases as the surface area of top surface 208 increases. For illustrative purposes, a silicon device, such as an integrated-gate bipolar transistor (IGBT), can be as large as, for example, approximately 15 mm by approximately 15 mm to carry several 100As of current. Even if mechanical pressure were to be homogeneously applied to the silicon device, the silicon device may still crack, as some silicon devices are only approximately 40 nm thick.

In accordance with various implementations of the present disclosure, the mechanical pressure applied to first body 202 and/or second body 204 in sintering can be substantially reduced or eliminated. As such, first body 202 and second body 204 can have a substantially reduced risk of being damaged and the reliability of the sintering product can be enhanced. Therefore, first body 202 and second body 204 can be sintered into electrical modules, whereby process yields of these often expensive modules can be greatly improved.

Referring to flowchart 100 of Figure 1 and to Figure 2B, flowchart 100 includes placing the first body (e.g., 202), the second body (e.g., 204), and the sinter material (e.g., 206) in a pressure chamber (e.g., 210) (172 in Figure 1). Figure 2B illustrates a perspective cross-sectional view, which includes a portion of a system for producing an electrical module processed according to an implementation disclosed in the present application. In particular, Figure 2B shows system 272, which includes first body 202, second body 204, sinter material 206, pressure chamber 210, conduit 220, valve 222, pressure generator 224, and braces 226a and 226b.

In system 272, first body 202, second body 204, and sinter material 206 have been placed in pressure chamber 210. In the present implementation, first body 202 and second body 204 have been placed in pressure chamber 210 after placing sinter material 206 between first body 202 and second body 204 (170 in Figure 1). However, placement in pressure chamber 210 may occur before or concurrently with placing sinter material 206 between first body 202 and second body 204.

In the implementation shown, pressure chamber 210 includes sidewalls 210a, 210b, and 210c. Although not specifically shown, pressure chamber 210 further includes another sidewall, such that the sidewalls of pressure chamber 210 completely surround first body 202. Pressure chamber 210 further includes top 210d, such that pressure chamber 210 can enclose first body 202, sinter material 206, and at least a portion of second body 204 (e.g. a portion of top surface 212 of second body 204).

In the present implementation, pressure chamber 210 includes gasket 214, which is situated under sidewalls 210a, 210b, 210c, and the sidewall not shown. Bottom opening 216 of pressure chamber 210 is configured to at least receive first body 202. First body 202, second body 204, and sinter material 206 can be placed in pressure chamber 210 by enclosing first body 202 over second body 204. This can be accomplished by mechanically engaging gasket 214 with top surface 212 of second body 204. For example, mechanical pressure may be applied to press gasket 214 down on second body 204. This mechanical pressure is on, or primarily on, second body 204 (e.g. a substrate), which can be more rugged than first body 202 (e.g. a semiconductor die), and does not pose a significant risk to damaging second body 204. Gasket 214 is configured to seal pressure chamber 210, such that gas and/or liquid pressure can be controlled within pressure chamber 210. Thus, pressure chamber 210 can be made substantially air tight after being pressed on secondy body 204.

In other implementations, gasket 214 is mechanically engaged with a support body that is situated below second body 204. Thus, neither of first body 202 nor second body 204 may be subjected to mechanical pressure from pressure chamber 210. These implementations may be suitable where neither of first body 202 nor second body 204 is sufficiently large enough to be engaged with gasket 214 in the manner shown in Figure 2B.

In some implementations, the form and shape of pressure chamber 210 is configured such that it can accommodate only one first body 202, as shown, to minimize the chamber volume to be pressurized during sintering (i.e. pressure chamber 210 is unable to accommodate another body that is substantially similar to first body 202). Similarly, in some implementations, pressure chamber 210 is configured such that it can accommodate only one second body 204 to minimize the chamber volume to be pressurized during sintering (i.e. pressure chamber 210 is unable to accommodate another body that is substantially similar to second body 204).

Also, in some implementations, pressure chamber 210 is configured to sinter multiple bodies similar to first body 202 (e.g. multiple dies or various different bodies) to second body 204 or to different bodies similar to second body 204 (e.g. different substrates) therein, and may enclose a larger area. An entire substrate panel (e.g. a DBC-card, a multi-chip card, or a lead frame panel) can be enclosed in pressure chamber 210 to sinter various building blocks of dies in one sintering process.

In system 272, at least one brace, such as braces 226a and 226b, can be utilized to mechanically fix relative positions of first body 202 and second body 204 during sintering. Braces 226a and 226b are configured to engage first body 202 with second body 204 by pressing first body 202 into second body 204. Other approaches may be utilized by braces 226a and 226b to fix relative positions of first body 202 and second body 204. Examples of braces 226a and 226b include a spring and a press. In some implementations braces 226a and 226b are part of a die bond machine or similar.

Referring to flowchart 100 of Figure 1 and to Figure 2C, flowchart 100 includes applying non-mechanical pressure in the pressure chamber (e.g., 210) to form an electrical module (e.g., 230) by attaching the first body (e.g., 202) to the second body (e.g., 204) using the sinter material (e.g., 206) (174 in Figure 1). Figure 2C illustrates a perspective cross-sectional view, which includes a portion of a system for producing an electrical module processed according to an implementation disclosed in the present application. In particular, Figure 2C shows system 274, which includes first body 202, second body 204, sinter material 206, pressure chamber 210, conduit 220, valve 222, pressure generator 224, and braces 226a and 226b after attaching first body 202 to second body 204 utilizing sinter material 206.

Pressure generator 224 is configured to apply non-mechanical pressure in pressure chamber 210 to form electrical module 230 by attaching first body 202 to second body 204 using sinter material 206. In particular, pressure generator 224 generates a pressurized environment which is enclosed inside pressure chamber 210. The non-mechanical pressure is applied utilizing pressure medium 232, which is inside pressure chamber 210. Pressure generator 224 can include a pump, for example, a hydraulic pump. The non-mechanical pressure can be applied utilizing conduit 220 and valve 222 or other means.

Pressure medium 232 can include, for example, gas and/or liquid. Thus, the non-mechanical pressure can include gas pressure and/or liquid pressure. Pressure generator 224 can thereby apply the non-mechanical pressure by compressing pressure medium 232. In some implementations, pressure medium 232 includes inert gas, such as helium, neon, argon, krypton, xenon, and/or radon. Other examples of pressure medium 232 include air and nitrogen gas. Generally, pressure medium 232 may be selected so as to avoid negatively impacting the formation of electrical module 230. Thus, is may be desirable that pressure medium 232 does not chemically interact with sinter material 206, first body 202, or second body 204.

Sinter material 206 (e.g. paste or powder) forms an intermetallic bond between first body 202 and second body 204 when pressure and temperature is applied over a reaction time. The temperature, pressure, and reaction time in pressure chamber 210 can be adjusted via, for example, pressure medium 232. The pressure applied in pressure chamber 210 to form electrical module 230 can be primarily non-mechanical pressure from pressure medium 232. Thus, the non-mechanical pressure can be, for example, approximately 1 megapascal (MPa) to approximately 90 MPa, or less. The temperature in pressure chamber 210 can be approximately 100 C or greater. Furthermore, the reaction time can be, for example, approximately 2 seconds to approximately 10 minutes. The pressure, temperature, and reaction time can be adjusted depending on the composition of sinter material 206 and other process conditions. Also, the pressure and/or temperature can be varied over the reaction time.

By applying non-mechanical pressure in pressure chamber 210 to form electrical module 230 by attaching first body 202 to second body 204 using sinter material 206, the mechanical pressure utilized to sinter first body 202 to second body 204 can be substantially reduced or eliminated. In some implementations, substantial mechanical pressure is still applied to first body 202 to sinter first body 202 to second body 204. However, by reducing the mechanical pressure utilized to sinter first body 202 to second body 204, the constituents of electrical module 230 are less prone to damage, such as cracking via sintering. The mechanical pressure may be applied by at least one of braces 226a and 226b, which can include a mechanical press or stamp.

In other implementations, the mechanical pressure utilized for sintering is substantially eliminated. In one implementation, braces 226a and 226b are not utilized, such that the sintering is contactless to first body 202. In other implementations, mechanical pressure applied by braces 226a and 226b has a nominal impact on sintering, but is sufficient to fix relative positions of first body 202 and second body 204. Furthermore, the mechanical pressure may not be significantly more than what is needed to press first body 202 into sinter material 206 (e.g. silver paste) to form a good connection. This implementation can also be utilized to reduce or eliminate the risk of pressure medium 232 permeating sinter material 206 in an uncured state. For example, sinter material 206 can be a semi-porous material at risk of being permeated by pressure medium 232.

Thus, in accordance with various implementations of the present disclosure, non-mechanical pressure in pressure chamber 210 is utilized to attach first body 202 to second body 204 while substantially reducing the risk of damaging first body 202 and second body 204. Sinter material 206 can thereby form a bond between first body 202 and second body 204 that is highly resistant to degradation and can stay substantially stable in temperature ranges that semiconductor devices (such as silicon devices) are typically exposed to in operation. The method allows for high reliability and yield while at the same time reducing or avoiding damage to semiconductor dies or other bodies. For example, the present disclosure enables sintering of ultra thin semiconductor dies that are less than approximately 70 nm thick and would otherwise be damaged by mechanical pressure (e.g. where first body 202 is an ultra thin semiconductor die).

It is noted that in some implementations, any number of pressure chamber 210, first body 202, second body 204, and sinter material 206 can be provided whereby the method illustrated by flowchart 100 in Figure 1 is performed substantially in parallel with each pressure chamber 210. Thus, various implementations of the present disclosure are compatible with high volume applications.

Implementations of the present disclosure can be utilized in many applications and the present disclosure generally relates to sintering two or more bodies. One particular application that is especially suitable is to provide interconnections in power modules. In one implementation, electrical module 230 is a power module of a power supply or a motor drive. For example, electrical module 230 may be suitable for automotive based applications including automotive hybrid or pure electric automotive applications due to harsh automotive environments and frequent power cycling that can degrade soldered interconnects.

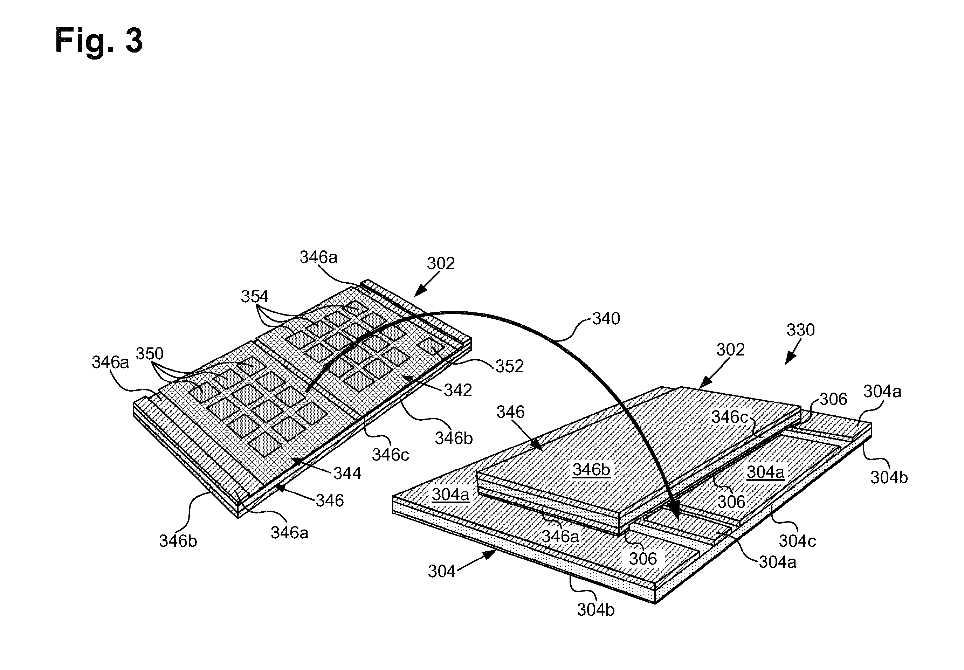

Referring now to Figure 3, Figure 3 illustrates a perspective view of formation of an electrical module according to an implementation disclosed in the present application. In particular, Figure 3 illustrates an implementation where electrical module 330, corresponding to electrical module 230 in Figure 2C, is a power module. Figure 3 shows first body 302, second body 304, and sinter material 306 corresponding respectively to first body 202, second body 204, and sinter material 206 in Figures 2A, 2B, and 2C.

As shown in Figure 3, first body 302 is a composite device including semiconductor die 342, semiconductor die 344, and substrate 346. Substrate 346 includes conductive layers 346a and 346b and dielectric layer 346c. Substrate 346 is a DBC, by way of example, but can be a different type of substrate, such as an IMS. Conductive layer 346a of substrate 346 can optionally be etched, as shown, so as to recess semiconductor die 342 and semiconductor die 344 within conductive layer 346a.

Semiconductor die 344 includes electrode pads 350 and semiconductor die 342 includes electrode pads 352 and 354. Semiconductor die 342 and semiconductor die 344 also each include additional electrode pads that are sintered to conductive layer 346a on a surface that opposes the surface having the electrode pads shown in Figure 3. The additional electrode pads are sintered to conductive layer 346a utilizing the method illustrated by flowchart 100 in Figure 1. For example, semiconductor die 344 may correspond to first body 202 and substrate 346 may correspond to second body 304. Alternatively, soldering can be employed or any of semiconductor dies 342 and 344 can be insulated from substrate 346.

Semiconductor die 342 can be, as one example, a transistor, such as an IGBT. Electrode pads 354 can correspond to a source/emitter of the transistor, electrode pad 352 can correspond to a gate of the transistor, and at least one of the additional electrode pads sintered to conductive layer 346a can correspond to a drain/collector of the transistor. Semiconductor die 344 can be, as one example, a diode. Electrode pads 350 correspond to an anode of the diode and at least one of the additional electrode pads sintered to conductive layer 346a can correspond to a cathode of the diode. Semiconductor die 342 and semiconductor die 344 can thereby be electrically connected to one another through substrate 346.

Also shown in Figure 3, second body 304 is a substrate, such as a DBC, but may be an IMS or another type of substrate, and includes conductive layers 304a and 304b and dielectric layer 304c. Conductive layer 304a of second body 304 is patterned as shown so as to insulate electrode pads 352 and 354 of semiconductor die 342 from one another while exposing dielectric layer 304c.

Also shown in Figure 3, electrode pads 350 of semiconductor die 344 and electrode pads 352 and 354 of semiconductor die 342 are sintered to second body 304 utilizing the method illustrated by flowchart 100 in Figure 1, as indicated by arrow 340. Pressure chamber 210 of Figures 2B and 2C may be shaped so as to enclose semiconductor dies 342 and 344 and substrate 346. Thus, semiconductor dies 342 and 344 and substrate 346 can be concurrently sintered to second body 304. Furthermore, although first body 302 is formed as a composite device prior to electrical module 330, in other implementations, the additional electrode pads described above are concurrently sintered to conductive layer 346a with electrode pads 350, 352, and 354 being sintered to conductive layer 304a. Thus, top and bottom electrode pads of semiconductor dies 342 and 344 may be concurrently sintered to form electrical module 330.

Thus, as described above with respect to Figures 1, 2A, 2B, 2C, and 3, implementations of the present disclosure provide for a pressure generator configured to apply non-mechanical pressure in the pressure chamber to form an electrical module by attaching a first body to a second body using sinter material. By utilizing the non-mechanical pressure, the amount of mechanical pressure applied to the first body and/or the second body can be reduced or eliminated, thereby substantially reducing the risk of damaging the constituents of the electrical module.

From the above description it is manifest that various techniques can be used for implementing the concepts described in the present application without departing from the scope of those concepts. Moreover, while the concepts have been described with specific reference to certain implementations, a person of ordinary skill in the art would recognize that changes can be made in form and detail without departing from the scope of those concepts. As such, the described implementations are to be considered in all respects as illustrative and not restrictive. It should also be understood that the present application is not limited to the particular implementations described above, but many rearrangements, modifications, and substitutions are possible without departing from the scope of the present disclosure.

## Claims

1. A system for producing an electrical module, said system comprising:
a pressure chamber configured to receive a first body, a second body, and a sinter material therebetween;
a pressure generator configured to apply non-mechanical pressure in said pressure chamber to form said electrical module by attaching said first body to said second body using said sinter material.

2. The system of claim 1, wherein said pressure chamber is configured to enclose said first body over said second body.

3. The system of claim 1, wherein said pressure chamber comprises a bottom opening configured to receive at least said first body.

4. The system of claim 1, wherein said pressure chamber comprises a gasket configured to seal said pressure chamber.

5. The system of claim 1, wherein said non-mechanical pressure comprises gas pressure.

6. The system of claim 1, wherein said non-mechanical pressure is applied in said pressure chamber by an inert gas.

7. The system of claim 1, wherein said non-mechanical pressure comprises liquid pressure.

8. The system of claim 1, wherein said sinter material comprises silver.

9. The system of claim 1, comprising a brace configured to engage said first body with said second body.

10. The system of claim 1, wherein pressure applied in said pressure chamber to form said electrical module is primarily said non-mechanical pressure.

11. The system of claim 1, wherein pressure applied in said pressure chamber to form said electrical module further includes mechanical pressure.

12. The system of claim 1, wherein said first body comprises a semiconductor die.

13. The system of claim 1, wherein said first body comprises a heat sink.

14. The system of claim 1, wherein said second body comprises a substrate.

15. A method comprising:
placing a sinter material between a first body and a second body;
placing said first body, said second body, and said sinter material in a pressure chamber;
applying non-mechanical pressure in said pressure chamber to form an electrical module by attaching said first body to said second body using said sinter material.
